Europäisches Patentamt

European Patent Office

Office européen des brevets

(19)

(11) Veröffentlichungsnummer: **0 567 683 B1**

(12) **EUROPÄISCHE PATENTSCHRIFT**

(45) Veröffentlichungstag der Patentschrift: **15.03.95**

(51) Int. Cl.⁶: **G01D 5/20**, G05F 1/44, G01R 19/02, G01P 3/46

(21) Anmeldenummer: **92107458.9**

(22) Anmeldetag: **30.04.92**

(54) **Einrichtung zum Erfassen der Signalamplitude der Erregerspannung eines Resolvers.**

(43) Veröffentlichungstag der Anmeldung:
**03.11.93 Patentblatt 93/44**

(45) Bekanntmachung des Hinweises auf die Patenterteilung:
**15.03.95 Patentblatt 95/11**

(84) Benannte Vertragsstaaten:
**AT DE FR GB IT SE**

(56) Entgegenhaltungen:
EP-A- 0 308 656
EP-A- 0 374 641
WO-A-90/15968
US-A- 4 143 315
US-A- 4 705 969

ELECTRONIOUE RADIO PLANS Nr. 515, Oktober 1990, Paris, FR, Seiten 69-74, JONGBLOET: "Le convertisseur RMS AD 637"

(73) Patentinhaber: **SIEMENS AKTIENGESELL-SCHAFT**
**Wittelsbacherplatz 2**
**D-80333 München (DE)**

(72) Erfinder: **Donat, Albrecht, Dipl.-Ing.**
**Westring 20**
**W-8531 Dachsbach (DE)**
Erfinder: **Segger, Bernd**
**Isarstrasse 4/III**
**W-8520 Erlangen (DE)**
Erfinder: **Hild, Bernhard, Dipl.-Ing.**
**Schiessäckerstrasse 24**
**W-8523 Beiersdorf (DE)**
Erfinder: **Vogt, Hartmut, Dipl.-Ing.**
**Anna-Herrmann-Strasse 34**
**W-8522 Herzogenaurach (DE)**

**Beschreibung**

Die Erfindung bezieht sich auf eine Einrichtung zum Erfassen der Signalamplitude der überkoppelten Erregerspannung eines Resolvers, die sich aus der mit einem Koppelfaktor bewerteten Erregerspannung ergibt. Bei regelungstechnischen Anwendungen in der Antriebstechnik, für die ein Resolver eingesetzt wird, ist es nötig, die Amplitude der überkoppelten Resolvererregungsspannung zu kennen bzw. auf einen bestimmten Wert zu regeln. Prinzipiell gibt es für die Erfassung der Signalamplitude zwei Möglichkeiten:

1. Ausnutzung der mathematischen Beziehung

$$\sin^2 (alpha) + \cos^2 (alpha) = 1.$$

Dieses verfahren hat den Nachteil, daß zur Auswertung teure Multiplizierer zur Quadratbildung benötigt werden.

2. Abtastung des Sinussignals im Cosinus-Nulldurchgang und Abtastung des Cosinussignals im Sinus-Nulldurchgang. Mit den abgetasteten Signal kann dann mit Hilfe von Komparatoren eine Aussage über die Signalamplitude gewonnen werden. Der Nachteil dieses Verfahrens liegt in der Trägheit des Systems, da zu einem endgültigen Ausregeln der Signalamplitude mehrere Abtastwerte erforderlich sind, was aber eben auch bedeutet, daß der Resolver mehrere Umdrehungen laufen muß, ehe die Signalamplituden ihren gewünschten Wert annehmen.

In diesem Zusammenhang sei auf die WO-A-90/15968 verwiesen, aus der die Erzeugung einer drehzahlproportionalen Spannung mit Hilfe eines Resolversbekannt ist. Ferner ist aus der EP-A-308 656 die Erzeugung von Phasenmodulator-Positionssignalen in digitaler Form unter Verwendung eines Resolvers geläufig. Ein Rechenwerk zur Verknüpfung von um 90° el. zueinander versetzten Signalen ist prinzipiell aus der US-PS 47 05 969 bekannt.

Aufgabe der Erfindung ist es, mit möglichst geringem technischen Aufwand eine Einrichtung zum Erfassen der Signalamplitude der überkoppelten Erregerspannung eines Resolvers zu ermöglichen.

Gemäß der Erfindung wird diese Aufgabe dadurch gelöst, daß eine der Resolverausgangsspannungen direkt und die andere über einen Integrator an eine Addierstufe geschaltet wird, deren Ausgangssignal über eine Gleichrichterstufe und ein Glättungsglied geleitet wird, an dessen Ausgang ein der Signalamplitude der Erregerspannung entsprechendes Signal abgreifbar ist.

Eine erste vorteilhafte weitere Ausbildung der Erfindung ist dadurch gekennzeichnet, daß das Ausgangssignal des Glättungsglieds mit einem Referenzwert für die Signalamplitude der überkoppelten Erregerspannung des Resolvers vergleichbar ist und daß entsprechend dem Differenzergebnis über einen Regler die Signalamplitude der Erregerspannung des Resolvers regelbar ist. Damit kann nach der Erfassung der Signalamplitude nunmehr auch eine Regelung der Signalamplitude auf einen gewünschten Wert erfolgen.

In diesem Zusammenhang ist es weiterhin vorteilhaft, daß als Regler ein solcher mit integralem Verhalten vorgesehen ist und daß die Beeinflussung der Signalamplitude der Erregerspannung des Resolvers über einen im Signalpfad "Generator für die Erregerspannung-Resolver" angeordneten Multiplizierer geschieht. Damit ist ein äußerst geringer Schaltungsaufwand verbunden.

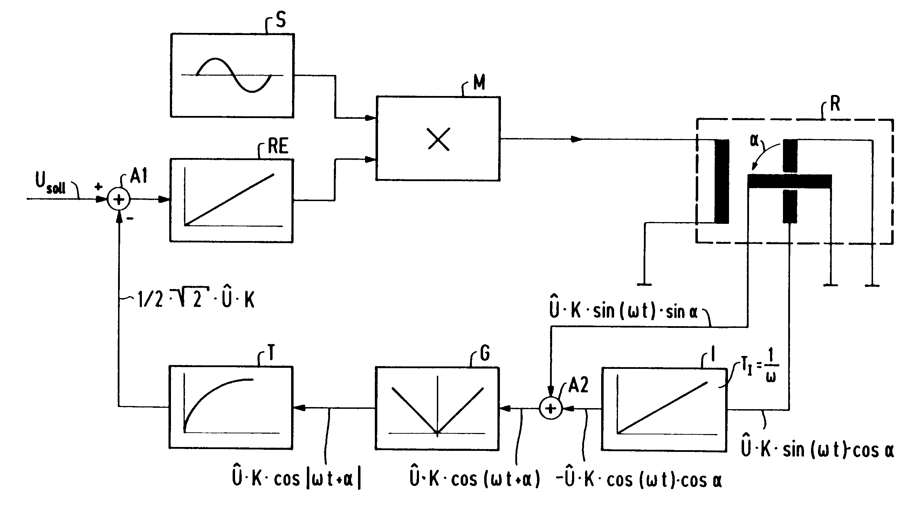

Ein Ausführungsbeispiel der Erfindung ist in der Zeichnung dargestellt und wird im folgenden näher erläutert.

Die Darstellung zeigt einen Sinusoszillator S, der über einen Multiplizierer M, auf dessen Funktion im folgenden noch eingegangen wird, die Erregerspannung mit der Winkelfrequenz omega für einen Resolver R (gestrichelt angedeutet) liefert. Der Resolver R besteht aus einer stationären Wicklung und einem bewegten System zweier um 90° versetzter Wicklungen. Das bewegte System ist um Schwenkwinkel alpha drehbar. Je nach Größe des Winkels alpha ergeben sich an den Ausgängen des Resolvers R zwei zueinander verschobene sinusförmige Ausgangsspannungen. Die erste wird dabei als erstes Signal einer Addierstufe A2 zugeleitet. Diese Ausgangsspannung hat dabei einen Wert

$$\hat{U} . K . \sin (omega . t) . \sin (alpha).$$

Die zweite Ausgangsspannung des Resolvers R hat dementsprechend dem Wert

$$\hat{U} . K . \sin . (omega . t) . \cos . (alpha).$$

Diese zweite Spannung wird jedoch nicht direkt der Addierstufe A2 zugeleitet, sondern zunächst über einen Integrator I geleitet, der eine Integrationszeit $T_I = 1/omega$ aufweist. Demzufolge liegt am Ausgang des Integrators I ein Signal

$$-\hat{U} . K . \cos (omega . t) . \cos (alpha)$$

vor, das als zweites Signal der Addierstufe A2 zugeleitet wird. Am Ausgang der Addierstufe A2 liegt dann eine Spannung

$$\hat{U} . K . \cos (omega . t + alpha)$$

vor. Dieser Zusammenhang ergibt sich aus dem Additionstheorem.

Das Ausgangssignal der Addierstufe A2 gelangt an einen Gleichrichter G an dessen Ausgang dann das Signal

$$\hat{U} \cdot K \cdot \cos |omega\ t + alpha\,|$$

vorliegt, wobei der Tiefpaß T aus diesem Signal nunmehr ein der Amplitude des vom Sinusoszillator S generierten Signals entsprechendes Referenzsignal

$$0{,}5 \cdot (2)^{0{,}5} \cdot \hat{U} \cdot K$$

liefert. Dieses Referenzsignal kann mit einem entsprechend parametrisierten Wert für die Soll-Amplitude $U_{soll}$ in einer zweiten Addierstufe A1 verglichen werden und das Differenzsignal kann dann über einen Regler RE mit integralem Verhalten dem Multiplizierer M zugeleitet werden. Das Ausgangssignal des Reglers RE gibt dann sozusagen einen Faktor für den Multiplizierer M ab, um den dieser das Ausgangssignal des Sinusoszillators S verstärkt. Durch diesen geschlossenen Regelkreis ist ein Einstellen der Sollamplitude äußerst leicht möglich.

**Patentansprüche**

1. Einrichtung zum Erfassen der Signalamplitude der überkoppelten Erregerspannung eines Resolvers, die sich aus der mit einem Koppelfaktor bewerteten Erregerspannung ergibt, **dadurch gekennzeichnet,** daß eine der Resolverausgangsspannungen ($\hat{U} \cdot K \cdot \sin(omega \cdot t) \cdot \sin(alpha)$) direkt und die andere ($\hat{U} \cdot K \cdot \sin(omega \cdot t) \cdot \cos(alpha)$) über einen Integrator (I) an eine Addierstufe (A2) geschaltet wird, deren Ausgangssignal ($\hat{U} \cdot K \cdot \cos(omega \cdot t + alpha)$) über eine Gleichrichterstufe (G) und ein Glättungsglied (T) geleitet wird, an dessen Ausgang ein der Signalamplitude der Erregerspannung entsprechendes Signal ($\mathbf{0{,}5 \cdot (2)^{0{,}5} \cdot \hat{U} \cdot K}$) abgreifbar ist.

2. Einrichtung nach Anspruch 1, **dadurch gekennzeichnet,** daß das Ausgangssignal des Glättungsglieds (T) mit einem Referenzwert ($U_{soll}$) für die Signalamplitude der überkoppelten Erregerspannung des Resolvers (R) vergleichbar ist und daß entsprechend dem Differenzergebnis über einen Regler (RE) die Signalamplitude der Erregerspannung des Resolvers (R) regelbar ist.

3. Einrichtung nach Anspruch 2, **dadurch gekennzeichnet,** daß als Regler (RE) ein solcher mit integralem Verhalten vorgesehen ist und daß die Beeinflussung der Signalamplitude der Erregerspannung des Resolvers (R) über einen im Signalpfad "Generator für die Erregerspannung-Resolver (R)" angeordneten Multiplizierer (M) erfolgt.

**Claims**

1. A device for detecting the signal amplitude of the coupled exciting voltage of a resolver which results from the exciting voltage weighted with a coupling factor, characterised in that one of the resolver output voltages ($\hat{U} \cdot K \cdot \sin(omega \cdot t) \cdot \sin(alpha)$) is switched directly and the other ($\hat{U} \cdot K \cdot \sin(omega \cdot t) \cdot \cos(alpha)$) via an integrator (I) to an adder stage (A2), the output signal of which ($\hat{U} \cdot K \cdot \cos(omega \cdot t \cdot alpha)$) is fed across a rectifier stage (G) and a smoothing element (T), from the output of which a signal ($0.5 \cdot (2)^{0.5} \cdot \hat{U} \cdot K$) corresponding to the signal amplitude of the exciting voltage can be tapped.

2. A device as claimed in Claim 1, characterised in that the output signal of the smoothing element (T) can be compared with a reference value ($U_{soll}$) for the signal amplitude of the coupled exciting voltage of the resolver (R) and that in accordance with the difference result the signal amplitude of the exciting voltage of the resolver (R) can be regulated via a controller (RE).

3. A device as claimed in Claim 2, characterised in that by way of controller (RE) a controller with integral behaviour is provided and that the signal amplitude of the exciting voltage of the resolver (R) is influenced via a multiplier (M) arranged in the signal path "generator for the exciting voltage - resolver (R)".

**Revendications**

1. Dispositif pour déterminer l'amplitude d'un signal de la tension d'excitation surcouplée d'un résolveur, qui est obtenu à partir de la tension d'excitation pondérée par un facteur de couplage, caractérisé par le fait qu'on envoie l'une des tensions de sortie du résolveur ($\hat{U}.K.\sin(omega.t).\sin(alpha)$) directement, et l'autre tension de sortie du résolveur ($\hat{U}.K.\sin(omega.t).\cos(alpha)$) par l'intermédiaire d'un intégrateur (I) à un étage additionneur (A2), dont le signal de sortie ($\hat{U}.K.\cos(omega.t + alpha)$) traverse un étage redresseur (G) et un circuit de lissage (T), à la sortie duquel peut être prélevé un signal ($0{,}5.(2)^{0{,}5}.\hat{U}.K$) qui correspond à l'amplitude du signal de la tension d'excitation.

2. Dispositif suivant la revendication 1, caractérisé par le fait que le signal de sortie du circuit de lissage (T) peut être comparé à une valeur de référence ($U_{consigne}$) pour l'amplitude du signal de la tension d'excitation surcouplée du résolveur (R) et que l'amplitude du signal de la tension d'excitation du résolveur (R) est réglable en fonction du résultat de la différence, par l'intermédiaire d'un régulateur (RE).

3. Dispositif suivant la revendication 2, caractérisé par le fait qu'il est prévu, comme régulateur (RE), un régulateur à comportement intégral et que l'influence de l'amplitude du signal de la tension d'excitation du résolveur (R) est exécutée au moyen d'un multiplicateur (M) qui est disposé dans la voie de transmission du signal "générateur de la tension d'excitation - résolveur (R)".

$U_{soll}$

A1

S

RE

M

$\times$

R

$\alpha$

$1/2 \cdot \sqrt{2} \cdot \hat{U} \cdot K$

$\hat{U} \cdot K \cdot \cos |\omega t + \alpha|$

T

$\hat{U} \cdot K \cdot \cos (\omega t + \alpha)$

G

$-\hat{U} \cdot K \cdot \cos (\omega t) \cdot \cos \alpha$

$\hat{U} \cdot K \cdot \sin (\omega t) \cdot \sin \alpha$

A2

$\hat{U} \cdot K \cdot \cos (\omega t) \cdot \cos \alpha$

$\hat{U} \cdot K \cdot \sin (\omega t) \cdot \cos \alpha$

$T_1 = \dfrac{1}{\omega}$

I